# EUROPEAN PATENT APPLICATION

(11) **EP 4 672 618 A1**
(43) Date of publication of application: **31.12.2025**
(21) Application number: 25171257.6
(22) Date of filing: 17.04.2025
(51) Int. Cl.: H04B 1/04, H04B 1/00

(54) **APPARATUS AND DEVICES FOR CHIP-TO-CHIP COMMUNICATION**

(30) Priority: 28.06.2024 US 202418757600
(71) Applicant: Intel Corporation, Santa Clara, CA 95054 (US)
(72) Inventor: YAMADA, Shuhei, Vancouver, 98684 (US); YANG, Tae Young, Portland, 97229 (US); ZHOU, Zhen, Chandler, 85248 (US); ACIKALIN, Tolga, San Jose (US); FOUST, Kenneth P., Beaverton, 97007 (US); HORINE, Bryce D., Portland, 97229 (US)
(74) Representative: Viering, Jentschura & Partner mbB Patent- und Rechtsanwälte

(57) **Abstract**

An integrated circuit device including: a plurality of integrated circuit dies, wherein each integrated circuit die of the plurality of integrated circuit dies is configured to receive or transmit a respective baseband signal; and a further integrated circuit die including: a plurality of front-end circuits, wherein each front-end circuit of the plurality of front-end circuits is coupled to a respective integrated circuit die of the plurality of integrated circuit dies.

## Description

### Technical Field

Various aspects of this disclosure relate to methods and devices for Chip-to-Chip communication.

### Background

Chip-to-chip communication may refer to, in modern electronic systems, the transfer of data between multiple integrated circuit chips, chiplets, or dies within the same integrated circuit (IC) device or across different IC devices. The chip-to-chip communication may provide the necessary interconnection framework for complex electronic systems and may allow multiple IC chips, chiplets, or dies to function with a collaboration or cooperation. Chip-to-chip communication may facilitate the exchange of information, such as instructions, data, and control signals, between processors, memory modules, sensors, and other specialized components, and may enable parallel processing, data sharing, and coordination among the various parts of the system.

In modern electronic systems, chip-to-chip communication may be implemented through wired or wireless interconnects, which may face several challenges, such as signal integrity. At high frequencies, communication signals between chips may suffer from various issues, such as crosstalk, reflections, and frequency-dependent losses. Such problems may lead to data corruption, reduced signal quality, and increased error rates. While wired interconnects may particularly be susceptible to signal integrity issues due to their physical nature, wireless interconnect is not immune to signal integrity problems, as they may be affected by interference, multipath propagation, and other factors.

### Brief Description of Figures

In the drawings, like reference characters generally refer to the same parts throughout the different views. The drawings are not necessarily to scale, emphasis instead generally being placed upon illustrating the principles of the disclosure. In the following description, various aspects of the disclosure are described with reference to the following drawings, in which:
FIG. 1 shows a simplified representation of a multichip electronic device;
FIG. 2 shows a module device as an example of a 2.5D heterogeneous integration of integrated circuits or components;
FIG. 3 depicts a module device as an example of a 3D heterogeneous integration of integrated circuits or components;
FIG. 4 depicts an exemplary multi-chip-module (MCM) implemented with a Manhattan architecture;
FIG. 5 depicts an example of an MCM incorporating wireless interconnections;
FIG. 6 depicts a multichip device with wireless package-to-package communications;
FIG. 7 depicts an example of wireless board-to-board communications;
FIG. 8 shows an extension of wireless communication to rack-unit-to-rack-unit communication;
FIG. 9 shows a block diagram showing a wireless circuitry;
FIG. 10 shows an example of a radiofrequency front-end portion that may be implemented in the circuitry;
FIG. 11 shows an example of a radiofrequency integrated circuit or transceiver circuitry;
FIG. 12 shows an example of a transceiver chain;
FIG. 13 shows an illustrative example of an IC device in accordance with various aspects described herein;
FIG. 14 shows an illustrative example of an IC device in accordance with various aspects described herein;
FIG. 15A and 15B show an illustrative example of a channel architecture in accordance with aspects described herein;
FIG. 16 shows an exemplary graph;
FIG. 17 shows an illustrative example of an IC device in accordance with various aspects described herein;
FIG. 18A and 18B show an illustrative example of a channel architecture in accordance with aspects described herein;
FIG. 19 shows an exemplary transmission coefficient graph of a channel architecture.

### Description

Chip-to-chip communication relates to exchange of data between two or more integrated circuits or chips. Traditionally, chip-to-chip communication involved use of wired interconnects between chips, but with recent developments in respective technology areas, multiple chips in a device may communicate with each other via wireless chip-to-chip interconnects. Short-range wireless communication technologies, such as Wi-Fi, Bluetooth, Zigbee, NFC, may be used for communication. In various aspects, capacitive coupling (e.g. couplers) and/or antennas may be used to convey data. To transmit signals using capacitive/inductive coupling, chips must be designed with the necessary coupling elements, such as metal strips, pads, plates, or vias. When an electrical signal is applied to one of the couplers, it is detected at the other couplers through the electromagnetic coupling between the two devices.

An interconnect may refer to, in the context of chip-to-chip communication, the physical and logical interface that enables data transfer between at least two chips or dies. Interconnects may be particularly important for heterogeneous multi-chip architectures where different types of chips, such as CPUs, GPUs, memory, and application-specific accelerators, may need to exchange data. An interconnect may include a physical medium for communication of signals and/or data, which may be implemented using various technologies such as electrical wires (parallel buses or serial links), optical waveguides, or even wireless interconnects (like ultra-wideband antennas or couplers integrated on-chip).

Illustratively, an interconnect may include a package/PCB based wired interconnect. Traditionally such wired interconnects may have challenges to meet the increasing bandwidth and throughput demands of modern electronic systems. The routing of wires on a PCB may introduce a complexity and may become more challenging as the number of connections increases. The physical constraints and limited routing flexibility significantly may introduce challenges for the scalability and performance of systems.

For example, an interconnect may include silicon interposers or bridges that may be configured facilitating chip-to-chip communication by providing a high-density interconnect substrate. While such interconnects provided in traditional methods may offer improved signal routing compared to PCB-based methods, the number of traces and bumps required may be directly proportional to the desired throughput. In some examples, such constraints may result in routing congestion and may increase manufacturing complexity. The high density of traces and bumps can also lead to yield issues, thereby raising costs. Additionally, signal integrity and mechanical constraints limit the effective communication distance.

In some examples, an interconnect may include an optical interconnect that may be configured to convert electrical signals into optical signals for data transmission. Although optical interconnects may offer high bandwidth and low latency, the need for electrical-to-optical conversion may increase power consumption, form factor, and cost. The thermal management of laser components may introduce further technical challenges, as stringent thermal requirements may be needed to meet to ensure reliable operation. Optical interconnects may also lack support for multichip-to-multichip communication, like package/PCB based wired interconnects, silicon interposers, or bridges, which may limit their use in systems requiring extensive chip interconnections.

Wireless interconnects may eliminate the need for physical connections and may provide more flexibility in chip-to-chip communication. However, they may face significant challenges due to high over-the-air path losses, which degrades the signal-to-noise ratio (SNR) and limits communication distances. This method may result in higher power consumption to maintain signal integrity. Additionally, increasing the number of wireless streams may be difficult due to limited isolation between streams, which may limit the aggregated throughput. The wireless channel can also be affected by multipath interference caused by surrounding components, further degrading performance. Thus, wireless interconnects may be considered as currently limited in their ability to support high-throughput, low-latency communication required for advanced multichip systems.

Chip-to-chip communication may offer various benefits that may be considered as essential for the development of advanced electronic systems. It may distributing computational tasks across multiple chips or chiplets, allowing for improved performance through parallel processing and workload sharing. This may particularly be important in heterogeneous computing environments, where different types of processors, such as CPUs and GPUs, work together to handle diverse workloads. Further, chip-to-chip communication may provide a high-bandwidth, low-latency interconnection between memory modules and processors, enabling fast data access and reducing the performance bottlenecks associated with memory-bound tasks. Furthermore, chip-to-chip communication may facilitate the integration of specialized components, such as sensors, accelerators, and custom ASICs, into the system, allowing for the development of application-specific, highly optimized solutions.

To meet the computational demands for today's application, chips, modules, or chipsets that include and integrate multiple disaggregated resources are used. One way to increase the performance or power of a processor is to increase the number of computational elements or transistors on the processor. However, as the size of transistors has shrunk, the transistor doubling frequency noted in Moore's Law industry has decelerated, thereby limiting the usefulness of this strategy.

In the era of advanced semiconductor manufacturing, the industry may be considered as progressively adopting leading-edge silicon process nodes to enhance the performance and functionality of ICs. However, this transition may come with significant challenges, particularly in terms of manufacturing yield and cost. As the process nodes become more sophisticated, the yield of large-sized dies decreases, while the manufacturing costs may continue to rise. Furthermore, designs that surpass the maximum reticle size may not be fabricated as a single monolithic IC, necessitating a de-integration approach. This technique, known as "chiplet" technology, may involve splitting a large silicon design into smaller, more manageable silicon pieces.

In accordance with various aspects described herein, a chip-to-chip communication architecture may include a disaggregated passband communication architecture, which may be considered as a disaggregated version of monolithic passband system into baseband portion (e.g. baseband circuit) and passband front-end portion (e.g. front-end circuit). In accordance with various aspects described herein, with the presence of multiple baseband circuits disposed on a substrate of an IC device at multiple locations, multiple front-end circuits, in which each front-end circuit provided for a respective baseband circuit of the multiple baseband circuits, may be co-located within the same die (e.g. in a single die). This die may also include an on-chip or an off-chip channel interface to carry passband signals (e.g. a broadcast channel architecture).

In such an architecture as described above, through co-location of the front-end circuits in a same die may minimize channel path loss while it may extend the link distance by extending respective transmission lines that may connect the baseband circuits and the front-end circuits respectively. In more detail, shorter distance arranged for the chip-to-chip communication interconnect compared to traditional systems in conjunction with low-loss transmission lines carrying baseband signals may extend the link distance in a designated communication performance. Furthermore, the architecture may enable chip-to-chip communication (e.g. chip-to-chip broadcast) interconnect with high-throughput, high-efficiency, low-latency at varying distances while it may avoid a large number of bumps and routing congestions. Through this architecture, a seamless interconnection between multiple dies may be enabled.

In accordance with various aspects described herein, the multiple front-end circuits co-located in the die may allow an LO sharing scheme, which may support communication link with improved signal integrity compared to general wireless interconnect technique, disaggregated architecture that may aligned with chiplet architecture, higher data rate, low latency, and any-cast/multi-cast/ and/or /multichip-to-multichip interconnect capabilities. In some examples, the aspects described herein may be implemented for various data center interconnect applications.

Some aspects provided herein may include use of chiplets, some of which are in general applicable for chips or integrated circuits. As used herein, the term "chiplet" includes an integrated circuit block of a multichip module (MCM) or of MCM devices. An MCM device may be an IC device. A chiplet can be considered as a sub-processing unit or a disaggregated functional resource with a specialized function that is designed to integrate with other chiplets of a same multichip device or module. A chiplet may be fabricated on its own individual semiconductor die with physical dimensions that are often smaller than other chips or processors. The MCM unit provides interconnections of the chiplets so as to form complete electronic function(s). In other words, a chiplet may refer to a small IC that may form part of a larger IC device. Instead of designing a single, large monolithic chip, multiple smaller chiplets that each performing specific functions may be employed. These chiplets may be interconnected to work together as a unified system.

In aspects of the disclosure, where appropriate, the term "die" may refer block of semiconductor material on which a component, e.g., a chip or chiplet is fabricated. In appropriate cases the term "die" may be used to refer to the integrated circuit fabricated from the semiconductor material (e.g., a chip, chiplet, etc.). Alternatively, or additionally, a die may refer to a small block of semiconductor material, typically silicon, on which a given functional circuit may be fabricated. A die may represent the actual circuitry that performs the intended electronic functions. Once fabricated, each die may be packaged to form an individual IC or can be used as a chiplet in an IC device. The term "die" may be referred to as "integrated circuit die" herein.

An MCM or MCM can be an electronic assembly that may be a single package including multiple components or modules or circuitries. An integrated device described herein may include an MCM. In examples herein, an MCM can be a plurality of chiplets arranged in a single package including die-to-die interconnect schemes for connecting the chiplets. In such cases, the chiplets of an MCM can be integrated and mounted onto a unifying substrate, so that in use it can be treated as if it were a larger IC. The unifying substrate may be the package carrier or package carrier substrate. The chiplets (and possibly other components) of the MCM may also share a common encapsulation and a common integrated heat spreader (IHS).

An MCM may in some cases include components other than chiplets. That is, an MCM may include integrated devices with their own packaging, such as, for example, central processing units (CPUs), graphics processing units (GPUs), neural processing unit (NPU), field programmable gate arrays (FPGA), etc. These such components with their own packaging can be arranged on a common substrate or base layer within relatively close proximity to each other in the MCM.

As used herein, "racks" or "rack enclosures" may be any type of equipment for housing electronic equipment. Racks house multiple types or sets of electronic equipment with an individual set of electronic equipment being housed within a single rack unit of the rack. Rack units of a rack may be stacked closely together, e.g., vertically in some cases. In aspects of the present disclosure, a rack unit may contain or hold one or more circuit boards or simply "boards". Each board can include a plurality of electronic devices, e.g., chips, chiplets, one or more multichip devices mounted the board. A rack may include multiple rack units that may be enclosed or contained in a common frame structure or chassis.

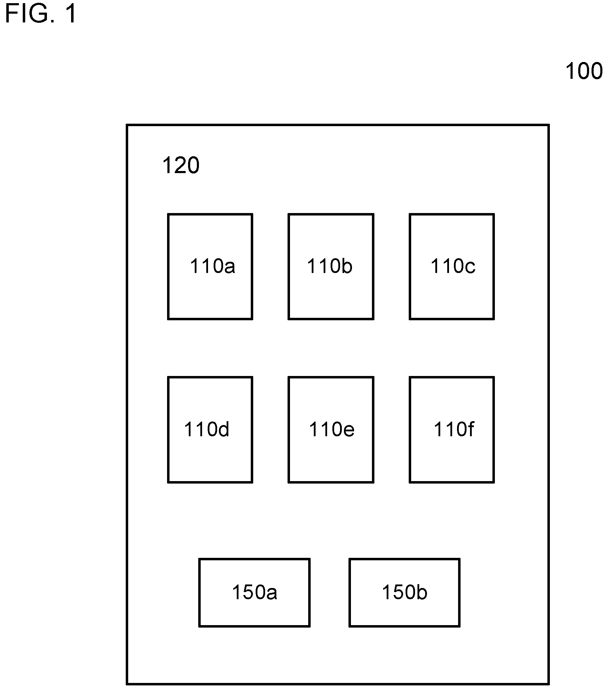

FIG. 1 shows a simplified representation of a multichip electronic device 100, which may be or may include an IC device in accordance with various aspects described herein. The device 100 includes a plurality of chiplets 110a-f. Each of the chiplets 110a-f may include one or a plurality of processor-cores or cores. In addition to the chiplets 110a-f, the electronic device 100 may include other hardware and/or software resources as represented by the blocks 150a and 150b. For example, the electronic device 100 may include elements or components such as, for example, processors (e.g., CPU, GPU, AI engine, etc.), random access memory (RAM), read-only memory (ROM), erasable programmable ROM (EPROM), electrically erasable programmable ROM (EEPROM), application specific integrated circuit (ASIC), etc.), software, hardware, and/or firmware.

The device 100 may include a base layer or a substrate 120 for mounting, on which the chiplets and other components can be mounted. In some cases, the substrate 120 may be a printed circuit board (PCB), including wired connections between the components, e.g., wired connections between the chiplets and wired connections for the resources 150a-b.

The device 100 of FIG. 1 can be considered as a 2D (two-dimensional) device because the components the mounted on a single plane. However, the above approach may be of less value because area of the mounting plane (e.g., real estate) may be not sufficient to allow enough components for a particular application. Further, the connections of a base layer like a PCB (e.g., conductive traces) may be unsuitable for applications requiring fast interconnections.

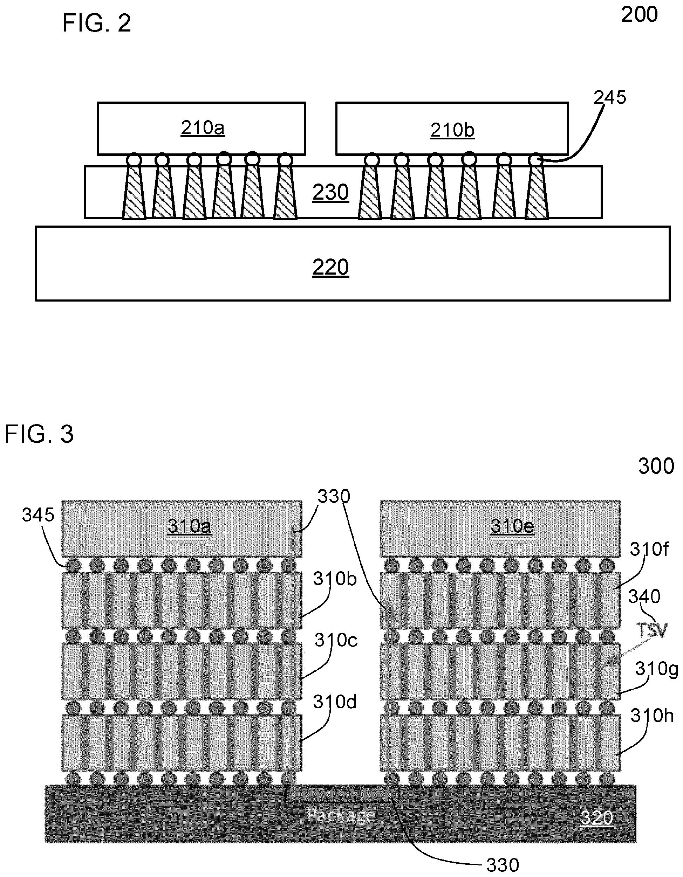

Another architectural approach for increasing computational power is the use of 2.5 dimensional (2.5 D) packages. One example of a 2.5D package is shown in the device 200 of FIG. 2, which may be or may include an IC device in accordance with various aspects described herein. 2.5D packages, can include multiple components, e.g., chips or chiplets mounted on an interposer. Conventionally, 2.5D semiconductor packages place several or chips side-by-side on a silicon interposer. This can be seen in FIG. 2, where in the device 200, the chips or chiplets 210a and 210b are mounted using bumps 245 on the interposer 230. The interposer itself can be mounted on the base layer, the package carrier, or the substrate 220.

An interposer is an electrical interface routing. For example, an interposer can provide interconnections between the components (e.g., chips, chiplets, etc.), as well as the external input/outputs (I/Os) through the use of through-substrate vias or through-silicon vias (TSV). Interposers can be silicon interposers that have lateral dimensions larger than the chips or components they are interconnecting.

Further, 2.5D package devices may also include bridges. For example, silicon bridges are a small piece of silicon that can be embedded under the edges of two components and provide interconnections therebetween. This can allow for most chips or components to be attached in multiple dimensions and thus eliminate additional physical constraints on heterogeneous chip attachment within the theoretical limits. In other words, an embedded multi-die interconnect bridge (EMIB) or bridges are essentially embedded into a standard packaging substrate and are used to provide high interconnect density exactly where needed, while the rest of a standard packaging substrate can be used for the rest of the interconnects.

Another architectural approach for improving devices is the use of three-dimensional (3D) stacking of semiconductor devices or components. The components (e.g., chips or chiplets) can be arranged in 3 dimensions instead of 2 dimensions. This allows the components of a device or module to be placed in closer proximity to one another.

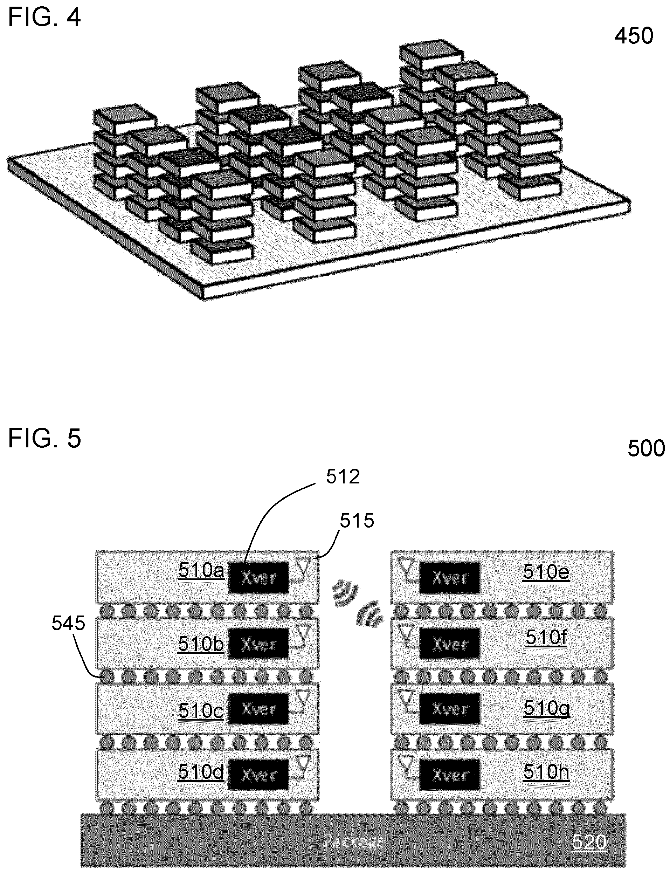

The module device 300 of FIG. 3 and FIG.4 is one example of a 3D heterogeneous integration of integrated circuits or components (e.g., chiplets), which may be or may include an IC device in accordance with various aspects described herein. The device 300 integrates disaggregated components in vertical stacks. The device includes at least a first vertical stack of chiplets 310a-d and a second vertical stack of chiplets 310e-f. In some examples, the chiplets may be any type of hardware component, e.g., include any type of processor (e.g., CPU, GPU, etc.), AI engine, accelerator, memory, or other suitable or desired component. As shown, the vertically adjacent chiplets are connected to one another using TSVs 340 and bumps 345. Further, the packaging substrate 320 providing a mount for each stack can further include a bridge 330 for connecting the vertical stacks of chiplets. Specifically, the bridge 330 can directly connect the lower chiplet/component 310d of one stack with the lower chiplet/component 310h of the second stack. One example of a bridge is an embedded multi-die interconnect bridge (EMIB).

3D heterogonous integrated devices may be built with a Manhattan-like architecture which includes large X-Y arrays of heterogeneous chiplets (e.g., CPU, GPU, AI, memory, etc.), and each chiplet can be positioned as on a chess board, having several stacked dies. FIG. 4 depicts a device 450 which is an MCM implemented with a Manhattan architecture. The vertical dimension allows for greater connectivity and more design possibilities. Further, the 3D heterogeneous integration of resources may provide devices that provide improved performance, cost efficiency, and design flexibility, compared to monolithic integration. Since the most advanced silicon technologies are economically feasible for chiplets with the most performance-intensive functions, it is advantageous to disaggregate these chiplets from chiplets based on prior generation node. Therefore, chiplet-based 3D heterogeneous integration approach to product development not only promises to reduce cost, but also can improve time-to-market.

In various examples, communication between chiplets may often require the use of many connections. The more and more components are added, thereby requiring communication with each other, the more the traffic in the TSVs, EMIBs, interposers, etc. increases. This increase in traffic may present problems in cases where high-transport data connections are needed. For example, to create an aggregate data transport of 1 Tbps, 30 to 50 interconnect lines might be needed. While such data transports may be possible, in some cases, for communication between neighboring chips, it may be physically and economically unfeasible to provide such data transports for larger integrations that involve hundreds of interconnect lines between horizontal and vertical stacked chips. Further, the cost of a silicon interposer is proportional to the area of that interposer. So, in cases needing several or many localized high-density interconnects, the costs can quickly accumulate. In short, TSV silicon interposers are relatively expensive and do not scale well for applications that require a massive number of components e.g., chiplets. Further, wires (interconnects) that connect together chips or chiplets degrade in performance with scaling. That is, wires can dominate the performance, functionality and power consumption of ICs.

In accordance with various aspects, the use of wireless Chip-to-Chip interconnects may also be an approach for realizing high-speed transport that would meet the requirements for high-performance computing products and applications. The wireless chip-to-chip (WC2C) technology can complement wired communications. WC2C can provide additional flexibility for high-performance computing products by enabling broadcast and multipoint-to-multipoint links with significant advantages for dynamically reconfigurable data-center networks.

It is to be noted herein that the aspects described in accordance with FIGs 5-8, or some other figures, may describe aspects for a WC2C communication, but this may not be considered as limiting toward the aspects and the nature of the interconnect as described. These aspects may apply to any type of interconnects at an extent, also for the wired interconnects, with a difference towards the physical medium of the interconnect. While for the WC2C communication, the physical medium may be considered as air, the aspects for wired interconnect may differ for the physical medium and the components that transfer the communication signals into the physical medium (e.g. wires, TSVs, silicone interposers, bridges, optical converters, etc.).

FIG. 5 shows an example of an MCM (MCM) 500 incorporating wireless interconnections. The MCM 500 includes a 3D integration of disaggregated resources (e.g., chiplets 510a-e). The chiplets 510 can be stacked and mounted on a package substrate 520. To enable wireless connection, each chiplet or component can include a wireless interconnect component (e.g., an antenna or antenna structure 515 or a coupler) and radio circuitry, e.g., transceiver circuitry 512. In addition, module 500 can include or provide wired communication between components. Similar to the module 300 of FIG. 3, the chiplets 510 may include TSVs (not shown) and bumps 545 that can allow for vertical interconnection. Further, the packaging substrate 520 can include bridges (e.g., EMIBs) and other types of interconnects or routing lines for providing connections between components.

WC2C communication may permit dense chiplet based products and supplement existing chip to chip communications, e.g., wired interconnections. As shown in the example of FIG. 5, the chiplet 510a can directly communicate wirelessly with the chiplet 510f. Therefore, in aspects of the present disclosure, the use of WC2C communication can be used to greatly relieve or reduce the data traffic through TSVs, interposers, or bridges and improve device performance, efficiency and allow for greater and more massive 3D heterogeneous integration. According to aspects of the present disclosure, to implement WC2C communication, an MCM such as the module 500 may implement protocols that can be divided into a control plane and a data plane. The data plane may carry the network data (e.g., in-module data) in accordance with the directives of the control plane. That is, the data plane may perform the actual forwarding of the data according to the configuration or routing paths managed and set forth by the control plane. In at least some cases, the data plane of WC2C communications may operate with frequencies in the 110-170GHz D-band using CMOS circuits with economical power efficiency. For example, in some aspects, the wireless interconnect components may have approximately 1mm of spacing. As CMOS technology continues to evolve and improve, higher frequencies, the reduction of the size and spacing of wireless interconnect components, and higher bandwidths can be realized.

The modules implementing WC2C communication can include control plane capabilities. That is, to augment the above-mentioned high-speed wireless data links or the data plane, control plane capabilities or functionalities can be included in the modules. Control plane functions implemented using wireless control signaling can establish the wireless data connections described herein. The control plane protocols can be used to establish wireless connections within a module or package and further to define routing paths for the data. For example, industry protocols, including Wi-Fi, I²C, USB, and/or other known protocol are possible.

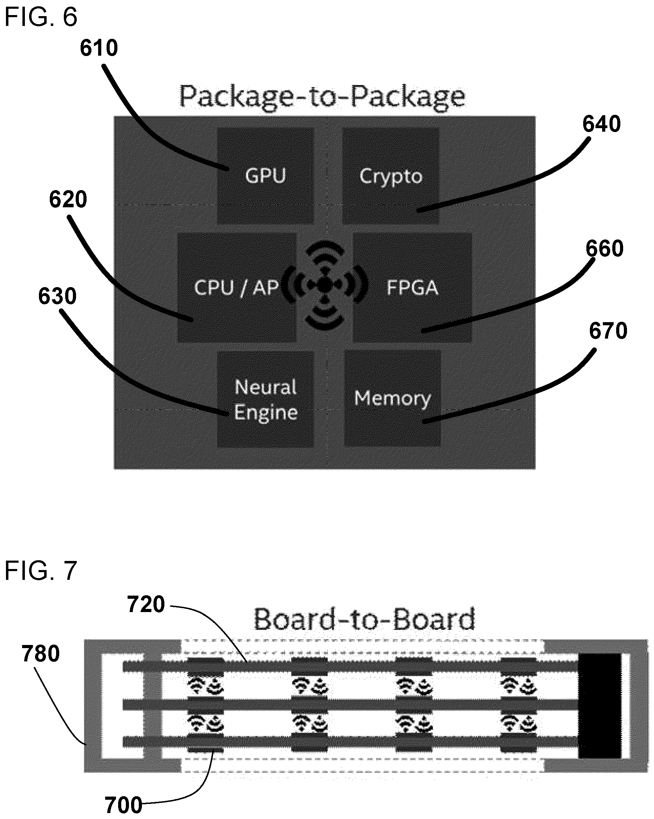

Control plane messages or control signaling may be in the form of packets to inform other components where to forward data or data messages. In some aspects, the control plane messages of an MCM may be implemented by using frequencies that differ from the data or data plane messages to manage and configure network data or data being transmitted to and from the components of a multichip device. In some cases, the messages may be implemented in a package-to-package type of communication scheme. For example, as described herein, a multichip device may include components that have their own individual packaging. (This is in contrast to an MCM of chiplets which may be packaged together (e.g., the dies of the chiplets share a common package)). In such cases, the multichip device may include wireless package-to-package communications. This is the scenario of FIG. 6, where in the device, the several components (GPU 610, CPU 620, Neural Engine 630, Cryptoprocessor 640, Field-programmable gate array (FPGA) 660, Memory device 670) have their own packaging which includes wireless circuitry to implement wireless package-to-package communications.

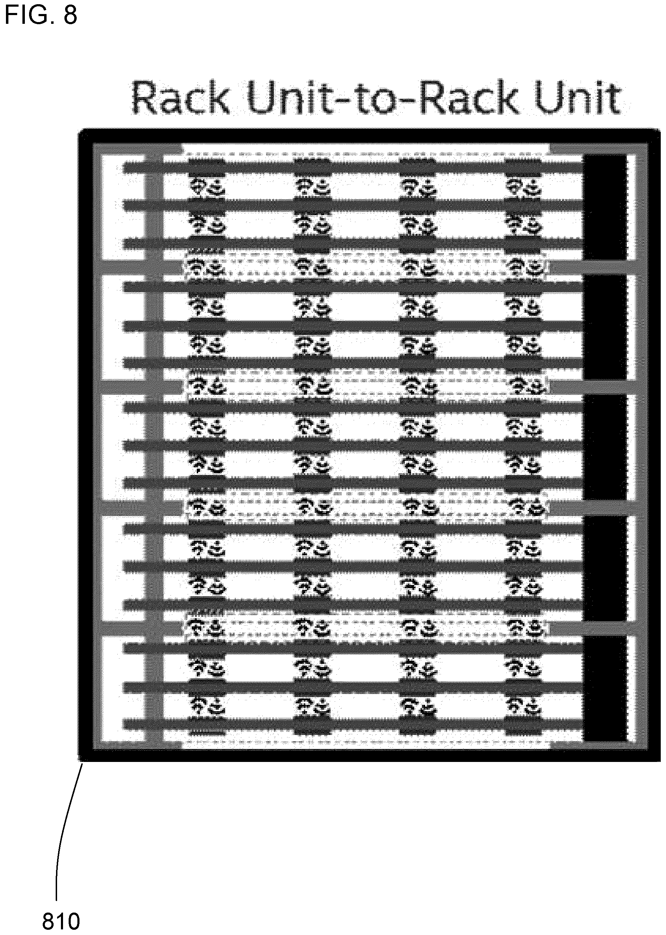

The control plane may manage communication not only for traffic within a multichip package (also denoted as in-package communication), but also may manage the communication between modules or packages e.g., MCMs or packages. This type of communication may be considered as wireless package-to-package communications. Furthermore, the control plane may be used for facilitating board-to-board communications in FIG. 7. That is, the devices or MCMs described herein can be mounted on boards, such as the boards 720, which in turn may be housed in a rack unit, such as the rack unit 780. In board-to-board communication, wireless communication may occur between the mounted devices (e.g., MCMs) of different boards 720. In addition, FIG. 8 shows that wireless communication may be extended to rack-unit-to-rack-unit communication, e.g., within a chassis 810 of the rack.

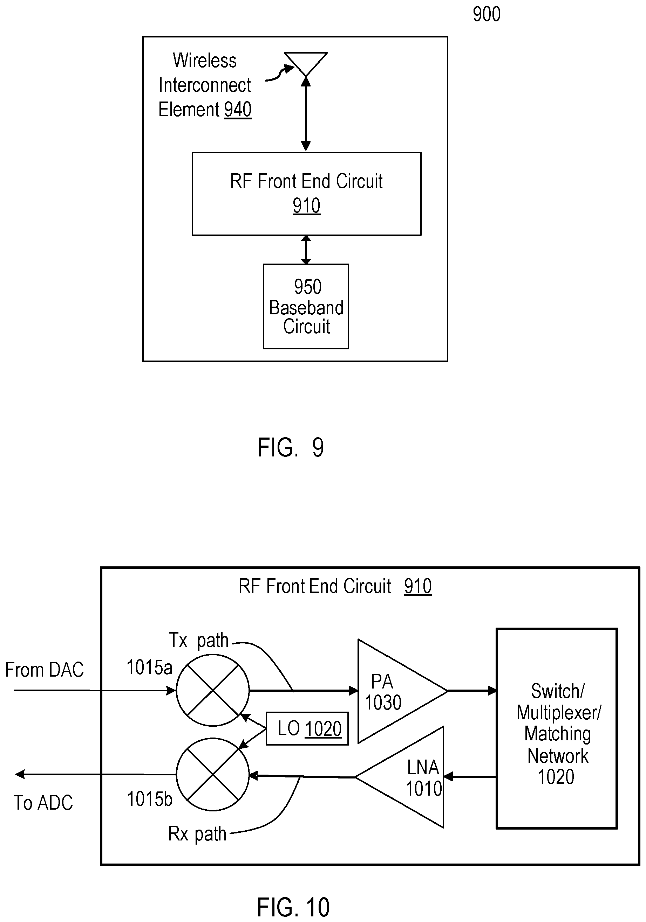

For the WC2C communications, both the data plane and control plane require the use of a RF circuitry. FIG. 9 shows a block diagram showing a traditional wireless circuitry 900. The wireless circuitry 900 includes a hardware component, e.g., a baseband circuit 950 for baseband signal processing, a front-end circuit 910 for radio frequency signal processing, and a wireless interconnect component 940, such as a coupler, an antenna, or antenna structure.

The front-end circuit 910 may include a transceiver (TRX) and a front-end. The transceiver may receive one or more baseband signals from the baseband circuit 950 and generate a passband signal as the communication signal for transmission from the circuitry 900 or receive a passband signal from the wireless interconnect component and generate a baseband signal for providing to the baseband circuit 950. The front-end circuit 910 may convert a baseband signal (i.e. baseband communication signal) into a format for transmission via the wireless interconnect component 940 and/or convert a passband signal received from the wireless interconnect component 940 into a baseband signal.

FIG. 10 shows an example of a portion of the front-end circuit 910 that may be implemented in the circuitry 900. The front-end circuit 910 may include a receiver circuit including components on a receive signal path and a transmitter circuit including components on a transmit path. A receive signal path (Rx path) of the front-end circuit 910 of FIG. 10 may include an LNA (low noise amplifier) 1010 for amplifying a received passband signal and may provide the amplified received passband signal to a mixer 1015b configured to down-convert the amplified received passband signal using an oscillator signal generated by the LO 1020 to a baseband signal to be sent to an ADC. In other words, the receiver circuit may include the LNA 1010, the mixer 1015b and the LO 1020. A transmit signal path (Tx path) of the front-end circuit 910 of FIG. 10 may include a mixer 1015a configured to up-convert a received baseband signal, which a DAC may provide, using the oscillator signal generated by the LO 1020 to an input passband signal and a PA (power amplifier) 1030 for amplifying the input passband signal into a passband signal for transmission. In other words, the transmitter circuit may include the mixer 1015a, the LO 1020, and the PA 1030. One or more filters may be included for generating suitable passband signals for transmission and reception. In addition, the front-end circuit 910 of FIG. 10 may include other components 1020 or circuitry, such as, for example, a tuner or matching network, switches, multiplexers, and/or other circuitry for coupling the depicted portion of the front-end circuit 910 to a wireless interconnect component 940 as illustrated in FIG. 9. In addition, other components may be included to support both transmit and receive modes. The front-end circuit 910 of at least FIG. 9 can provide signals obtained from the wireless interconnect component 940 to the baseband circuit 950.

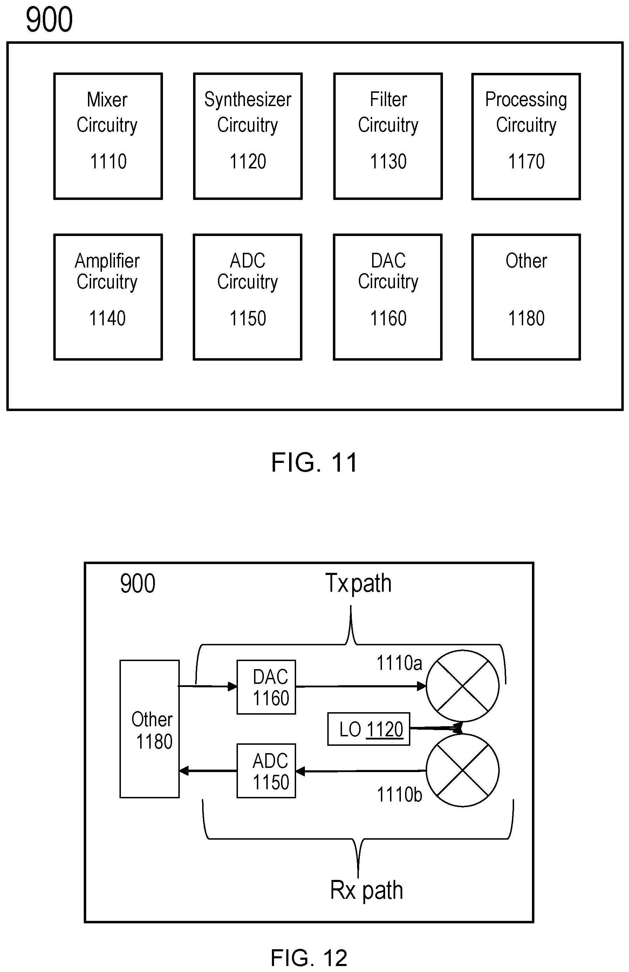

FIG. 11 shows one example of the wireless circuitry 900. As shown, the wireless circuity 900 can include components such as a mixer circuitry 1110, synthesizer circuitry 1120 (e.g., local oscillator), filter circuitry 1130 (e.g., baseband filter), amplifier circuitry 1140, analog-to-digital converter (ADC) circuitry 1150, digital-to-analog (DAC) circuitry 1160, processing circuitry 1170, and other suitable digital front-end (DFE) components 1180, to name a few. The processing circuitry 1170 may include a processor, such as one or more time-domain and/or frequency domain processor/components in at least one example. The other components 1180 may include logic components, modulation/demodulation elements, and an interface circuitry for interfacing with another component. Illustratively, the receiver circuit of the wireless circuitry 900 may include a first portion of these described circuitry while the transmitter circuit of the wireless circuitry 900 may include a second portion of these described circuitry.

DFE (digital front-end) components may include any suitable number and/or type of components configured to perform functions known to be associated with digital front-ends. This may include digital processing circuitry, portions of processing circuity, one or more portions of an on-board chiplet having dedicated digital front-end functionality (e.g., a digital signal processor), etc. The DFE components may selectively perform specific functions based upon the operating mode of the wireless circuitry 900 and, for example, may facilitate beamforming. Digital front-end components may also include other components associated with data transmission such as, for instance, transmitter impairment correction such as LO correction, DC offset correction, IQ imbalance correction, and ADC skew, digital pre-distortion (DPD) calculation, correction factor (CF) calculation, and pre-emphasis (pre. emp.) calculation. To provide additional examples, the digital front-end components may facilitate or perform receiver or transmitter digital gain control (DGC), up-sampling, down-sampling, zero crossing detection algorithms, phase modulation, perform beam management, digital blocker cancellation, received signal strength indicator (RSSI) measurements, DPD and calibration accelerators, test signal generation, etc.

In at least one example, the wireless circuitry 900 may include a receive signal path which may include mixer circuitry 1110, amplifier circuitry 1140 and filter circuitry 1130. In some aspects, the transmit signal path of the wireless circuitry 900 may include filter circuitry 1130 and mixer circuitry 1110. The wireless circuitry 900 may also include synthesizer circuitry 1120 for synthesizing a frequency signal for use by the mixer circuitry 1110 of the receive signal path and the transmit signal path. In some aspects, the mixer circuitry 1110 of the receive signal path may be configured to down-convert passband signals received from wireless interconnect component 940 based on the synthesized frequency provided by synthesizer circuitry 1120. In some aspects, the output baseband signals and the input baseband signals may be digital baseband signals. In such aspects, the front-end circuit 910 may include analog-to-digital converter (ADC) 1150 and digital-to-analog converter (DAC) circuitry 1160.

In at least one example, the wireless circuitry 900 may also include a transmit signal path (Tx path) which may include circuitry to up-convert baseband signals provided by e.g., a modem and provide passband output signals for transmission via the wireless interconnect component. In some aspects, the receive signal path may include mixer circuitry 1110, amplifier circuitry 1140 and filter circuitry 1130. In some aspects, the transmit signal path of the wireless circuitry 900 may include filter circuitry 1130 and mixer circuitry 1110. The wireless circuitry 900 may include synthesizer circuitry 1120 for synthesizing a frequency signal for use by the mixer circuitry 1110 of the receive signal path and the transmit signal path. The mixer circuitry 1110 of the receive signal path may be configured to down-convert passband signals received from the wireless interconnect component 940 based on the synthesized frequency provided by synthesizer circuitry 1120.

In various aspects, amplifier circuitry 1140 may be configured to amplify the down-converted signals and filter circuitry may be a low-pass filter (LPF) or band-pass filter (BPF) configured to remove unwanted signals from the down-converted signals to generate output baseband signals. Output baseband signals may be provided to another component for further processing. In some aspects, the output baseband signals may be zero-frequency baseband signals, although this is not a requirement.

The mixer circuitry 1110 for a receive signal path may include passive mixers, although the scope of this disclosure is not limited in this respect. In some aspects, the mixer circuitry 1110 for a transmit signal path may be configured to up-convert input baseband signals based on the synthesized frequency provided by the synthesizer circuitry 1120 to generate passband output signals for transmission via the wireless interconnect component 940.

In some aspects, the mixer circuitry 1110 of the receive signal path and the mixer circuitry 1110 of the transmit signal path may include two or more mixers and may be arranged for quadrature down-conversion and up-conversion, respectively. In some aspects, the mixer circuitry 1110 of the receive signal path and the mixer circuitry 1110 of the transmit signal path may include two or more mixers and may be arranged for image rejection (e.g., Hartley image rejection). In some aspects, the mixer circuitry 1110 of the receive signal path and the mixer circuitry 1110 may be arranged for direct down-conversion and direct up-conversion, respectively. In some aspects, the mixer circuitry 1110 of the receive signal path and the mixer circuitry 1110 of the transmit signal path may be configured for super-heterodyne operation.

In some aspects, the synthesizer circuitry 1120 may be a fractional-N synthesizer or a fractional N/N+1 synthesizer, although the scope of the aspects is not limited in this respect as other types of frequency synthesizers may be suitable. For example, synthesizer circuitry 1120 may be a delta-sigma synthesizer, a frequency multiplier, or a synthesizer including a phase-locked loop with a frequency divider. The synthesizer circuitry 1120 may be configured to synthesize an output frequency for use by the mixer circuitry 1110 of the radio circuitry 1120 based on a frequency input and a divider control input. In some aspects, the synthesizer circuitry 1120 may be a fractional N/N+1 synthesizer.

In some aspects, frequency input may be provided by a voltage-controlled oscillator (VCO), although that is not a requirement. In various cases, divider control input may be provided by a processing component of the front-end circuit, or may be provided by any suitable component. In some aspects, a divider control input (e.g., N) may be determined from a look-up table based on a channel indicated by external component.

In some aspects, synthesizer circuitry 1120 of the wireless circuitry 900 may include a divider, a delay-locked loop (DLL), a multiplier and a phase accumulator. In some aspects, the divider may be a dual modulus divider (DMD), and the phase accumulator may be a digital phase accumulator (DPA). In some aspects, the DMD may be configured to divide the input signal by either N or N+1 (e.g., based on a carry out) to provide a fractional division ratio. In some aspects, the DLL may include a set of cascaded, tunable, delay elements, a phase detector, a charge pump and a D-type flip-flop. The delay elements may be configured to break a VCO period up into No equal packets of phase, where Nd is the number of delay elements in the delay line. In this way, the DLL provides negative feedback to help ensure that the total delay through the delay line is one VCO cycle.

In some aspects, synthesizer circuitry 1120 may be configured to generate a carrier frequency as the output frequency, while in other aspects, the output frequency may be a multiple of the carrier frequency (e.g., twice the carrier frequency, four times the carrier frequency) and used in conjunction with quadrature generator and divider circuitry to generate multiple signals at the carrier frequency with multiple different phases with respect to each other. In some aspects, the output frequency may be a LO frequency (*f_{LO}*)*.* In some aspects, the front-end circuit 910 may include an IQ/polar converter.

FIG. 12 shows one example of a portion of the wireless circuitry 900 that may be implemented. The receive signal path (Rx path) circuitry down-converts passband signals received from the wireless interconnect component 940 and may provide baseband signals. Specifically, the receive signal path may include a mixer 1110b and an ADC 1150. The transmit signal path (Tx path) circuity up-converts provided baseband signals and provides passband output signals for transmission via the wireless interconnect component 940. Specifically, the transmit signal path may include a DAC 1160 and a mixer 1110a. The portion of the wireless circuitry 900 shown in FIG. 12 may include a synthesizer circuit, specifically, at least one local oscillator (LO) 1120 to generate reference signals for the mixers 1110a and 1110b.

The wireless interconnect component 940, illustrated in FIG. 9, may include a single antenna for transmission and reception. In other cases, the antenna or antenna structure 940 may include multiple transmit antennas in the form of a transmit antenna array and multiple receive antennas in the form of a receive antenna array. In other cases, the wireless interconnect component 940 may be one or more antennas to be used as transmit and receive antennas. In such cases, the front-end circuit 910 may include, for example, a duplexer, to separate transmitted signals from received signals. In some examples, the wireless interconnect component 940 may include couplers (i.e. capacitive/inductive couplers).

While the transceivers described herein include traditional super-heterodyning schemes or architectures, other type of transceiver or transmitter architectures and schemes may be used. In some aspects, the transceiver chain of the wireless circuitry 900 may include components so as to implement a near zero IF scheme, a Direct Conversion scheme, or a digital transmission scheme, such as, for example, a Digital IQ transmission, a Digital Polar transmission, and the like.

In one example, the wireless circuitry 900 may include a transmit path that includes or implements a direct digital transmitter (DDT). That is, in one simple example, a DDT may include a digital signal processor, a RF digital-to-analog converter (RFDAC), a PA, and a RF filter/antenna coupler. Referring back to FIG. 12, in cases where the DAC 1160 is a direct RF DAC that produces RF output directly from digital input, the mixer 1110a can be omitted from the transmit path.

For example, a DDT may be implemented with or without an IQ-mixer. In general, a RFDAC may be included on a front-end circuit to convert digital input into a passband signal. A DDT may include other digital components such as numerically controlled oscillator (NCO) and digital mixers for shifting an input signal to desired frequency. The use of a DDT can reduces the number of analog components needed in the transmitter or transmit path. For example, analog LOs, analog filters, analog mixers, and etc., may be eliminated from the wireless circuitry 900 when a direct digital transmitter (DDT) is employed. Further, the use of a digital transmitter or digital transmission schemes such may bring energy savings and efficiencies.

As indicated before, aspects are described herein for a chip-to-chip communication architecture may include a disaggregated passband communication architecture, which may illustratively separate the baseband circuit 950 and the front-end circuit 910 described in accordance with FIGs. 9-12 on separate dies. In this constellation, circuitry and components described in accordance with FIGs. 11 and 12 for the wireless circuitry 900 may be disaggregated between the baseband circuit 950 and the front-end circuit 910. Illustratively, while the baseband circuitry 950 include a first portion of the circuitry and components described in accordance with FIGs. 11 and 12, which may be configured for generating, processing, and/or manipulating signals at the baseband to output baseband signals, the front-end circuit 910 may include a second portion of the circuitry and components described in accordance with FIGs. 11 and 12, which may be configured for providing conversion between the baseband signals received from the baseband circuit 950 and passband signals and/or manipulating passband signals for a transmission with the wireless interconnect element 940.

Illustratively, in accordance with various aspects described herein, a baseband circuit may include the ADC circuitry 1150 and the DAC circuitry 1160 to provide conversion between digital signals and analog baseband signals. Illustratively, in the transmit path, the baseband circuit may include the DAC circuitry 1160 to convert the received digital communication signal to an analog baseband signal. In the receive path, the baseband circuit may include the ADC circuitry 1150 to convert a received analog baseband signal to a digital signal. In this constellation, a front end circuit may include the mixer circuitry 1110 to provide up- and down-conversion. For example, in the transmit path, the mixer 1110a may up-convert the analog baseband signal received from the baseband circuit to obtain a passband signal. In the receive path, the mixer 1110b may down-convert a received passband signal into the analog baseband signal to be transmitted to the baseband circuit. As described above, the front end circuit may further include the PA 1030, and the LNA 1010 and the switch/multiplexer/matching network 1020, while the baseband circuit may further include

In particular, aspects described herein may include an IC device including multiple baseband circuits 950, where each baseband circuit may be disposed on one or more substrates of the IC device spatially at a different location than other baseband circuits, and a front-end die that includes multiple front-end circuits 910, each front-end circuit being coupled to a respective baseband circuit of the multiple baseband circuits. Illustratively, the multiple baseband circuits may be distributed on different dies for facilitating communication between these dies. Correspondingly, all front-end circuits may be co-located and aggregated into a single die, which may also include one or more wireless interconnect components 940 for transmitting and/or receiving passband signals with an on-chip channel structure (e.g. for communication within the IC device between multiple baseband circuits) or with an off-chip channel structure (e.g. for communication with at least one further front-end circuit of a further baseband circuit, which the further front-end circuit is not disposed on the front-end die).

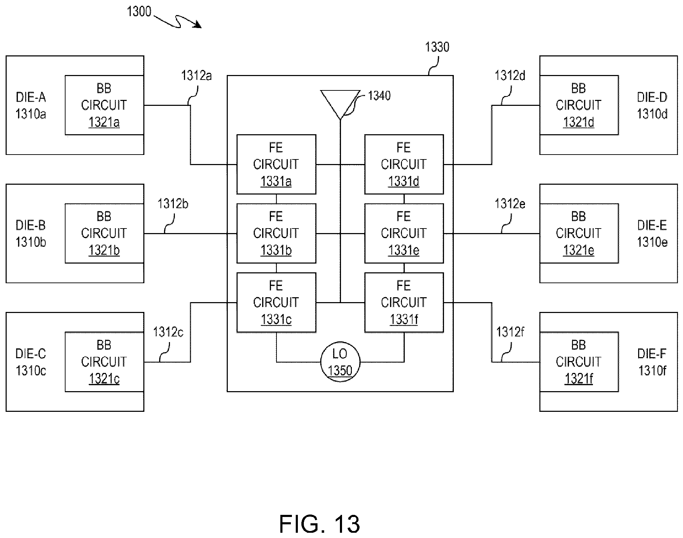

FIG. 13 shows an illustrative example of an IC device in accordance with various aspects described herein. The IC device 1300 may be an MCM as described herein including a plurality of dies 1310a-f. Illustratively, each die 1310a-f may be a chiplet (e.g. 110a-f) configured for a designated function for the operation of the IC device 1300. Each die 1310a-f may include a respective baseband circuit 1321a-f. There are six dies illustrated in this illustrative example, but the IC device 1300 may include any number of dies. In particular, the IC device 1300 may include more dies that are not illustrated herein and the IC device 1300 may further communicate with further dies that another one or more IC devices may include.

Each chiplet or die 1310a-f may be configured to perform specific functions within the IC device 1300. For example, die 1310a may be a CPU chiplet configured for general-purpose computing tasks, while die 1310b may be a GPU chiplet dedicated to graphics processing and parallel computing. Die 1310c may be an AI accelerator chiplet configured for machine learning workloads, and die 1310d may be a memory controller chiplet configured to manage the memory resources of the IC device 1300. Dies 1310e and 1310f may be input/output (I/O) chiplets handling external connectivity and communication with peripherals. In some examples, each die 1310a-f may be a computing die configured to provide a designated computing function (i.e. processing). It is to be noted that all functional configurations described herein are exemplary, and each die 1310a-f may be configured for a designated function that may operate with an exchange of information with other dies that may include the dies 1310a-f. Illustratively, each die 1310a-f may include respective functional components (e.g. components, such as a respective processing circuitry) configured to provide the designated function of the respective die 1310a-f.

In other words, communication between each die 1310a-f and/or with other dies that are not illustrated herein may be essential for the coordinated operation of the IC device 1300. Each die 1310a-f may be configured for exchanging information to perform its designated function. For instance, the CPU chiplet of the die 1310a may need to communicate with the GPU chiplet of the die 1310b to offload graphics-intensive tasks. Similarly, the AI accelerator chiplet of the die 1310c may be configured to receive data from the sensor integration chiplet of the die 1310e for real-time processing. The memory control chiplet of the die 1310d may facilitate data transfer between the memory modules and the other processing units, to ensure quick access to data and reduce latency, etc.

The baseband circuits 1321a-f of each die 1310a-f may be configured to enable chip-to-chip communication. The baseband circuits 1321a-f may be configured for processing and generating communication signals as the baseband signals that are transmitted to other dies that may include the other dies of the dies 1310a-f and for receiving and processing incoming baseband signals from other dies that may include the other dies of the dies 1310a-f. The baseband signals carry the actual data and control information exchanged between the dies including the dies 1310a-f.

In TX direction, to obtain the baseband signals to be transmitted, each baseband circuit 1321a-f may interface with the functional components of its respective die. For example, in the CPU chiplet of the die 1310a, the baseband circuit 1321a may receive data and/or instructions from the CPU cores and memory of the die 1310a. The baseband circuit 1321a may then process and format information representing the data and/or instructions into baseband signals for transmission to other dies via a respective transmission line 1312a-f. Each baseband circuit 1321a-f may operate similarly by receiving information to be transmitted from the functional components of its respective die and generate baseband signals representing the information provided by the functional components of the respective die. In some examples, for the TX direction, each baseband circuit 1321a-f may include a respective digital to analog converter to obtain the respective baseband signal.

In RX direction, each baseband circuit 1321a-f may receive incoming baseband signals from a respective transmission line 1312a-f. Each baseband circuit 1321a-f may perform the necessary signal processing and data extraction, in which each baseband circuit 1321a-f may demodulate, decode, and interpret the received baseband signals to recover the original data and control information. Each baseband circuit 1321a-f may then forward this information to the functional components of its respective die 1310a-f for further processing or execution. In some examples, for the RX direction, each baseband circuit 1321a-f may include a respective analog to digital converter to convert the respective baseband signal into a digital signal to be processed by the respective baseband circuit 1321a-f.

It is to be noted that although aspects are described in a manner that chip-to-chip communication for each die 1310a-f may be bi-directional, this is mainly for illustrative purposes. In some examples, the communication may be uni-directional, or the respective communications may be bi-directional for one or more dies of the dies 1310a-f while the respective communications may be uni-directional for one or more further dies of the dies 1310a-f. It is to be noted that the one or more dies referred here are different from the further die 1330.

Each die 1310a-f and its respective baseband circuit 1321a-f may be configured to transmit baseband signals and/or receive baseband signals (i.e. or both). Correspondingly, each transmission line 1312a-f may include an RX transmission line to receive baseband signals and/or a TX transmission line to transmit baseband signals (i.e. or both). In some examples, each baseband circuit 1321a-f and its respective transmission line 1312a-f may be configured to both transmit and receive baseband signals, while at a particular time instance one or more baseband circuits 1321a-f may transmit signals while other one or more baseband circuits 1321a-f- may receive baseband signals. Illustratively, for a broadcasting operation, one of the baseband circuits (e.g. the baseband circuit 1321a) may be configured as a transmitter to transmit baseband signals, while other baseband circuits (e.g. the baseband circuits 1321b-f) may be configured as respective receivers to receive baseband signals representing the baseband signals transmitted by the transmitter. Various further examples are further described towards roles or nature of the communication associated with each die 1310a-f.

In the illustrated constellation of the dies 1310a-f, while each die 1310a-f is configured to receive or transmit a respective baseband signal, illustratively from or to the respective transmission line 1312a-f, the IC device 1300 may include a further die 1330, which may also be referred to as a front-end die. The further die 1330 may include a plurality of front-end circuits 1331a-f. Each front-end circuit 1331a-f- may be connected to one of the baseband circuits 1321a-f via the respective transmission line 1312a-f. The further die 1330 may include or may be coupled to one or more interconnect components 1340 (e.g. the wireless interconnect component 940 or other one or more wired interconnect components, some of which have been described herein). In some examples, the further die 1330 may be a single die. Illustratively, each front-end circuit 1331a-f may be coupled to the one or more interconnect components 1340 via a respective port.

Illustratively, the first baseband circuit 1321a included by the first die 1310a may be connected, via the first transmission line 1312a, to the first front-end circuit 1331a. Similarly, the second baseband circuit 1321b included by the second die 1310b may be connected, via the second transmission line 1312b, to the second front-end circuit 1331b. The third baseband circuit 1321c included by the third die 1310c may be connected, via the third transmission line 1312c, to the third front-end circuit 1331c. The fourth baseband circuit 1321d included by the fourth die 1310d may be connected, via the fourth transmission line 1312d, to the fourth front-end circuit 1331d. The fifth baseband circuit 1321e included by the fifth die 1310e may be connected, via the fifth transmission line 1312e, to the fifth front-end circuit 1331e. The sixth baseband circuit 1321f included by the sixth die 1310f may be connected, via the sixth transmission line 1312f, to the sixth front-end circuit 1331f.

In a transmitter configuration, the transmitter circuit of a front-end circuit of the frond end circuits 1331a-f may receive its respective baseband signal from its respective baseband circuit of the baseband circuits 1321a-f via its respective transmission line of the transmission lines 1312a-f, up-convert the received baseband signal with an oscillator signal (e.g. by mixing) to obtain its respective passband signal and transmit the respective passband signal via the one or more interconnect components 1340. Illustratively to describe this operation for the first front-end circuit 1331a, the transmitter circuit of the first front-end circuit 1331 may receive a first baseband signal from the first baseband circuits 1321 via the first transmission line 1312a, up-convert the first baseband signal with the oscillator signal that the LO 1350 provides to obtain a first passband signal, and transmit the first passband signal via the one or more interconnect components 1340.

In a receiver configuration, the receiver circuit of a front-end circuit of the front-end circuits 1331a-f may receive its respective passband signal via the one or more interconnect components 1340, down-convert the received passband signal with an oscillator signal (e.g., by mixing) to obtain its respective baseband signal, and transmit the respective baseband signal to its respective baseband circuit of the baseband circuits 1321a-f via its respective transmission line of the transmission lines 1312a-f. Illustratively, to describe this operation for the first front-end circuit 1331a, the receiver circuit of the first front-end circuit 1331a may receive a first passband signal via the one or more interconnect components 1340, down-convert the first passband signal with the oscillator signal provided by the LO 1350 to obtain a first baseband signal, and transmit the first baseband signal to the first baseband circuit 1321a via the first transmission line 1312a.

Each die 1310a-f in the IC device 1300 may be spatially disposed at different locations from the other dies for various reasons, some of which have been described above (e.g. the overall system performance, thermal management, signal integrity, etc). For example, the IC device 1300 may include a substrate and each die 1310a-f and the further die 1330 may be disposed on the substrate. In some examples, the IC device 1300 may include multiple substrates and the dies 1310a-f and the further die 1330 may be disposed on the multiple substrates. Illustratively, the dies 1310a-f and the further die 1330 may be disposed on designated surfaces of different substrates.

Each die 1310a-f may be connected to its respective front-end circuit 1331a-f via the respective transmission lines 1312a-f, which may be designed to accommodate the spatial separation. The transmission lines 1312a-f carrying lower frequency signals compared to traditional methods, as the respective front-end circuits 1331a-f performing up-conversion/down-conversion, may optimize to maintain signal integrity over the distances involved. In some examples, low-loss transmission lines 1331a-f may be used to connect each baseband circuit 1321a-f to its respective front-end circuit 1331a-f, may provide minimal signal degradation despite the spatial separation.

Furthermore, while the distance of transmission lines 1312a-f carrying respective baseband signals increasing, the distance of communication for respective passband signals may decrease as the respective front-end circuits 1331a-f- for each baseband circuit 1321a-f may be provided on the further die 1330 and correspondingly the one or more interconnect components 1340, such as antennas and/or couplers and/or wired interconnect components, may be placed at extremely close distance to minimize unnecessary path loss.

In accordance with various aspects described herein, the further die 1330 may include the one or more interconnect components 1340. In some examples, the one or more interconnect components may be referred to as a broadcast interface. The one or more interconnect components 1340 may be an interconnect architecture configured to carry passband signals for transmission to other dies and/or between the dies 1310a-f. In some examples, the one or more interconnect components 1340 may include a wireless interconnect component. In some examples, the one or more interconnect components 1340 may include a wired interconnect component. In various examples, the one or more interconnect components 1340 may include a broadcast channel architecture to carry broadcast passband signals to the other dies and/or between the dies 1310a-f. In some examples, the front-end circuits 1331a-f may be coupled to the one or more interconnect components, e.g. via an intermediate interface, the one or more interconnect components 1340 (i.e. the interconnect architecture) that may have been formed on the further die 1330 or on external substrate, such as package, base die, bridge die, etc. to form the broadcasting channel.

In some aspects, the further die 1330 may further include one or more oscillators. In this illustrative example, the further die includes a local oscillator (LO) 1350 configured to provide an oscillator signal to each front-end circuit 1331a-f. Due to co-location of the front-end circuits 1331a-f within the further die 1330, each front-end circuit 1331a-f may be configured to operate with a shared oscillator signal that may be shared with other front-end circuits 1331a-f, which may help to avoid carrier frequency offset between front-end circuit 1331a-f, in particular in cases in which one or more front-end circuits 1331a-f are configured to transmit passband signals and other one or more front-end circuits 1331a-f are configured to receive the passband signals transmitted by the one or more front-end circuits 1331a-f. This shared oscillator signal concept may also mitigate unwanted noises.

Illustratively, each front-end circuit 1331a-f may be coupled to one oscillator of the one or more oscillators configured to provide oscillator signals, in which at least two front-end circuit of the front-end circuits 133a-f may be configured to receive the same oscillator signal. Further, at least two front-end circuit of the front-end circuits 1331a-f may be configured to operate with respect to the same oscillator signal, such as at least two front-end circuit of the front-end circuits 1331a-f may be configured to up-convert received baseband signals and/or down-convert received passband signals using the same oscillator signal. In this example, the LO 1350 may be coupled to each front-end circuit 1331a-f and each front-end circuit 1331a-f may perform up-conversion and/or down-conversion using the shared oscillator signal provided by the LO 1350.

In some examples, the baseband circuits 1321a-f and the dies 1310a-f may be implemented via a leading-edge process (e.g., advanced CMOS nodes like 7nm or 5nm) that may offer high transistor density and performance, while the front-end circuits 1331a-f and/or the further die 1330 may be implemented using RF-friendly process or III-V semiconductor processes for high-frequency performance.

It is further to be noted that in various aspects described herein may further reduce routing complexity considering that one or more oscillators (e.g. the LO 1350) provided within the further die 1330 and power plane routing required for operation of the front-end circuits 1331a-f would be cumulated, which may further reduce the signal and power integrity. Further noting that the dies 1310a-f, through their respective baseband circuits 1321a-f and their respective transmission lines 1312a-f carrying respective baseband signals may be connected to their respective front-end circuits 1330a-f, the one or more interconnect components 1340 may be an off-package broadcasting interconnect.

In some examples, one of the baseband circuits 1321a-f and/or its respective front-end circuit 1331a-f may be configured for a transmission via the one or more interconnect components 1340 at a designated time instances in a transmitter configuration, while other baseband circuits 1321-a-f and/or their respective front-end circuits 1331a-f may be configured to receive the transmission via the one or more interconnect components 1340 in a receiver configuration. Illustratively, the first baseband circuit 1321a and the first front-end circuit 1331a may be designated to operate in the transmitter configuration for a time period, in which the first baseband circuit 1321a may send a baseband signal to the first front-end circuit 1331a, and the transmitter circuit of the first front-end circuit 1331a may receive the baseband signal, up-convert the baseband signal to obtain a passband signal, and transmit the passband signal via the one or more interconnect components. The other front-end circuits (i.e. the second, third, fourth, fifth, and sixth) 1331b-f may be configured to operate in the receiver configuration for the time period, in which the respective receiver circuit of each other front-end circuit 1331b-f may receive the passband signal, down-convert the passband signal to obtain a respective baseband signal, and transmit the respective baseband signal to the respective baseband circuit 1321b-f of the other baseband circuits.

In some examples, the above-mentioned transmitter-receiver configuration described for the time period may be predefined. Illustratively, one of the baseband circuits 1321a-f and/or its respective front-end circuit 1331a-f may be configured permanently for a transmission via the one or more interconnect components 1340 in the transmitter configuration, while other baseband circuits 1321-a-f and/or their respective front-end circuits 1331a-f may be configured permanently to receive the transmission via the one or more interconnect components 1340 in the receiver configuration. Illustratively, the respective baseband circuit and the respective front-end circuit that are in the transmitter configuration may be a dedicated broadcaster configured to broadcast communication signals to other dies.

In some examples, the above-mentioned transmitter-receiver configuration described for the time period may be dynamic, illustratively based on a received instruction or information. For example, each baseband circuit 1321a-f and its respective front-end circuits 1331a-f may form a respective transceiver operate as both receiver and transmitter. Each respective transceiver may include a respective transmitter circuit and a respective receiver circuit. Based on a received instruction, each respective transceiver may operate either in the transmitter configuration or in the receiver configuration. Illustratively, a processor and/or a controller may control which respective transceiver operates in the transmitter configuration and which respective transceiver operates in the receiver configuration.

In some examples, each baseband circuit 1321a-f and its respective front-end circuit 1331 may be configured to operate in the receiver configuration to receive passband signals transmitted via the one or more interconnect components 1340 by other dies of the IC device 1300 and/or by other dies of further IC devices that are connected to the one or more interconnect components 1340. In some examples, each baseband circuit 1321a-f and its respective front-end circuit 1331 may be configured to operate in the transmitter configuration to transmit passband signals via the one or more interconnect components 1340 to other dies of the IC device 1300 and/or to other dies of further IC devices that are connected to the one or more interconnect components 1340.

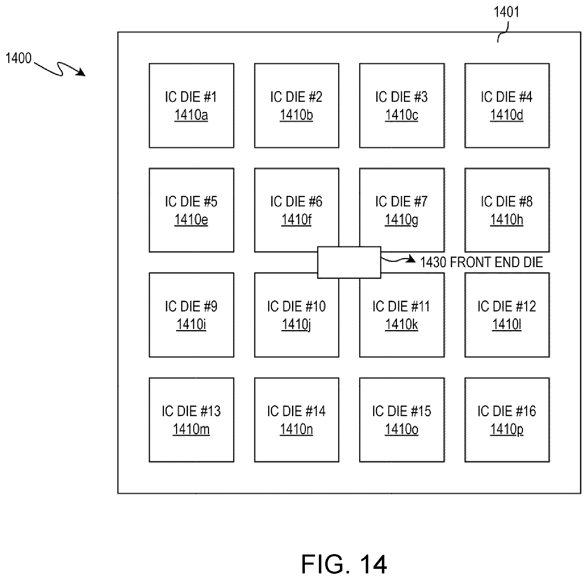

FIG. 14 shows an illustrative example of an IC device in accordance with various aspects described herein. the IC device 1400 may be the IC device 1300 described in accordance with FIG. 13, including 16 dies (e.g. computing dies, each configured to perform a respective computing operation). In this illustrative example, the IC device 1400 has been depicted to include 16 dies 1410a-p including respective baseband circuits but the IC device 1400 may include any number of dies. In particular, the IC device 1400 may include more dies that are not illustrated herein or less dies. In some examples, the IC device 1400 may further communicate with further dies that another one or more IC devices may include. Aspects described with respect to the dies 1310a-f in accordance with FIG. 13 are applicable for the dies 1410a-p. The IC device 1400 may further include a front-end die 1430 and aspects described with respect to the further die 1330 are applicable to the front-end die 1430.

To summarize the operation as described in accordance with FIG. 13, each die 1410a-p may include a respective baseband circuit that operates together with a respective front-end circuit included by the front-end die 1430, which the respective baseband circuit and the respective front-end circuit may be connected via a respective transmission line in-between, to form a respective transmitter, receiver, or transceiver, which is to be referred as "respective transceiver" for brevity, noting that aspects described herein may include examples in which respective baseband and front-end circuits may form a (sole) receiver and/or a (sole) transmitter. The respective baseband circuits transmit, in transmit direction, and/or receive, in receive direction, baseband signals from the respective transmission line and the respective front-end circuits receive baseband signals, in transmit direction and/or transmit, in receive direction, baseband signals from the respective transmission line. Since the front-end die 1430 and the respective baseband circuits implemented in each dies 1410a-p may be connected through respective transmission lines configured to carry signals at baseband, the link distance can be extended to support larger size package such as 100x100 mm.

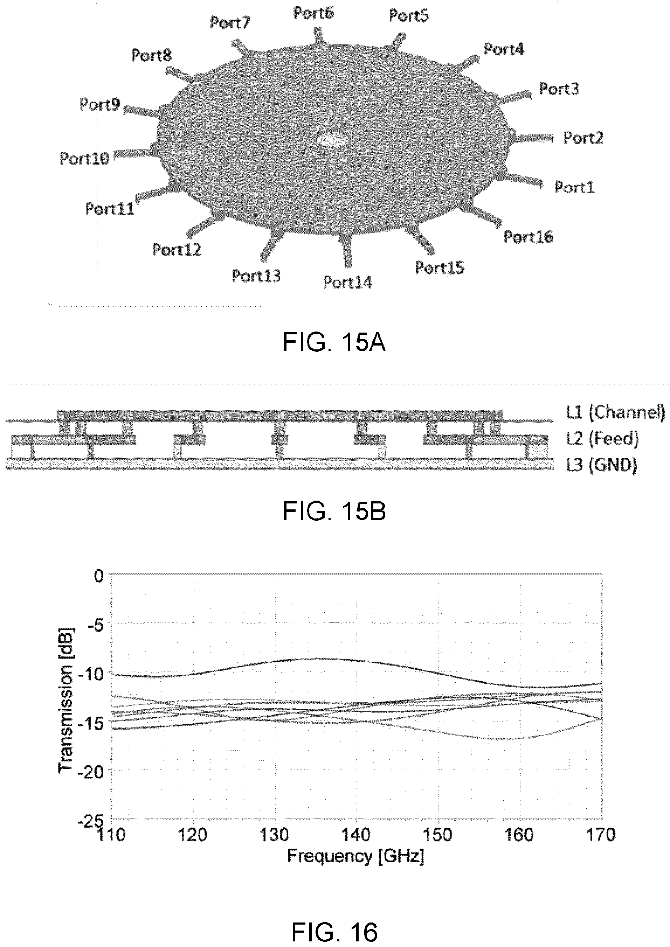

Each front-end circuit may be connected to one or more interconnect components (not depicted) that is exemplified here as a channel architecture, exemplarily illustrated in FIGs. 15A and 15B to transmit (in transmit direction) and/or receive (in receive direction) passband signals to/from the channel architecture. As illustrated herein, the IC device 1300 may have a substrate (e.g. a package) 1401 on which the dies 1410a-p and the front-end die 1430 are disposed. Illustratively, the channel architecture may also be disposed on the substrate (e.g. on the package). In some examples, the channel architecture may be disposed on the front-end die 1430. In some examples, the front-end die 1430 may be an IC package and the channel architecture may be disposed on the package of the front-end die 1430.

For efficient and effective signal integrity, the dies 1410a-p may be arranged in a grid (e.g. 4x4 gird), with each die may be disposed equidistantly spaced from its neighboring dies. In some examples, the front-end die 1430 and/or the channel architecture may be centrally disposed within the grid surrounded by the dies 1410a-p. Illustratively, the dies 1410a-p may be positioned at the perimeter of the grid, forming four edges in a square/rectangular shape, while the front-end die 1430 and/or the channel architecture may be located at the center, which may be arranged to maintain an equal distance from each die 1410a-p at the four edges. Such symmetrical disposition of dies 1410a-p around the front-end die 1430 may provide a uniform distance and may minimize signal degradation or latency.

In some examples, all respective transceivers may operate in the receiver configuration to receive transmit passband signals from the channel architecture. At least one of respective transceivers may operate in the transmitter configuration to transmit passband signals to the channel architecture while other respective transceivers may receive the passband signals transmitted by the respective transmitter operating in the transmitter configuration. In this constellation, the die including the respective baseband circuit of the respective transceiver operating in the transmitter configuration may broadcast information to other dies.

In some examples, the respective transceivers may change their transmitter-receiver configurations dynamically. Any known method may be implemented that would allow broadcasting information by different dies of the dies 1410a-p, such as channel access mechanisms, centralized channel access mechanisms, listen-before-talk mechanism, clear channel assessments, predefined channel allocations, etc., which may change the die that broadcast information and other dies that receive the broadcast information.

FIG. 15A and 15B show an illustrative example of a channel architecture in accordance with aspects described herein, while FIG. 15A shows the channel architecture from a perspective, FIG. 15B shows the cross section of the channel architecture. The channel architecture may be a radial or a circular channel architecture with a central hub and multiple ports (e.g. 16 ports as illustrated) arranged around the circumference. Each port may couple a respective front-end circuit that the front-end die 1430 includes. Each port may be configured to receive and/or transmit respective passband signals from and/or to the respective front-end circuit coupled to that port.

The channel architecture may have three layers. The first layer (L1) depicted in FIG. 15B illustrates the main data transmission channel carrying high-frequency passband signals for chip-to-chip communication. The channel architecture includes 16 ports surrounding the first layer and arranged radially around the first layer, at the second layer (L2) with feeds provided in between connecting each port to the main data transmission channel, which also connect to the ground layer. The channel architecture illustrated here may be disposed on the package in accordance with aspects described in FIG. 14.

FIG. 16 shows a graph example representing output of simulation results in accordance with the channel architecture illustrated in FIG. 15. The graph shows the presence of up to 17 dB of loss in the communication channel, yet the obtained signal to noise ratio (SNR) is sufficient to establish the broadcast communication with a bandwidth greater than 60 GHz with a reasonable error rate (<1e-9) due to aspects described herein.

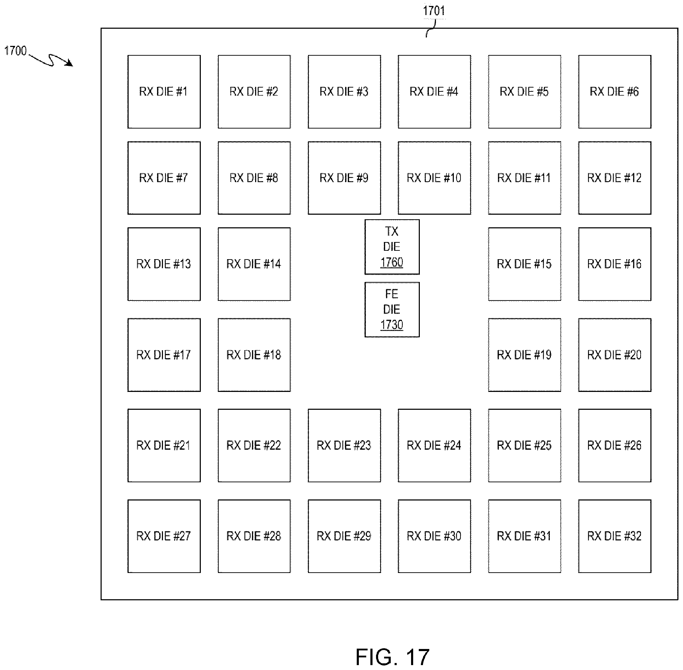

FIG. 17 shows an illustrative example of an IC device in accordance with various aspects described herein. The IC device 1700 may be the IC device 1300 described in accordance with FIG. 13, including 32 receiving dies (e.g. computing dies, each configured to perform a respective computing operation). In this illustrative example, the IC device 1700 has been depicted to include 32 receiving dies but the IC device 1700 may include any number of receiving dies. In particular, the IC device 1700 may include more dies that are not illustrated herein or less dies. In some examples, the IC device 1700 may further communicate with further dies that another one or more IC devices may include. Aspects described with respect to the dies 13 10a-f in accordance with FIG. 13 are applicable for the RX dies and the TX die 1760. The IC device 1700 may further include a front-end die 1730 and aspects described with respect to the further die 1330 are applicable to the front-end die 1730.

To summarize the operation as described in accordance with FIG. 13, each RX die may include a respective RX baseband circuit that operates together with a respective RX front-end circuit included by the front-end die 1730, which the respective RX baseband circuit and the respective RX front-end circuit may be connected via a respective transmission line in-between, to form a respective receiver. The respective RX baseband circuits of the RX dies receive, in receive direction, baseband signals from the respective transmission line and the respective RX front-end circuits transmit, in receive direction, baseband signals from the respective transmission line. Furthermore, the TX die 1760 may include a respective TX baseband circuit that operates together with a respective TX front-end circuit included by the front-end die 1730, which the respective TX baseband circuit and the respective TX front-end circuit may be connected via a respective transmission line in-between, to form a respective transmitter. The respective TX baseband circuit of the TX die 1760 transmit, in transmit direction, baseband signals to the respective transmission line and the respective TX front-end circuit transmit, in transmit direction, passband signals to the one or more interconnect components.

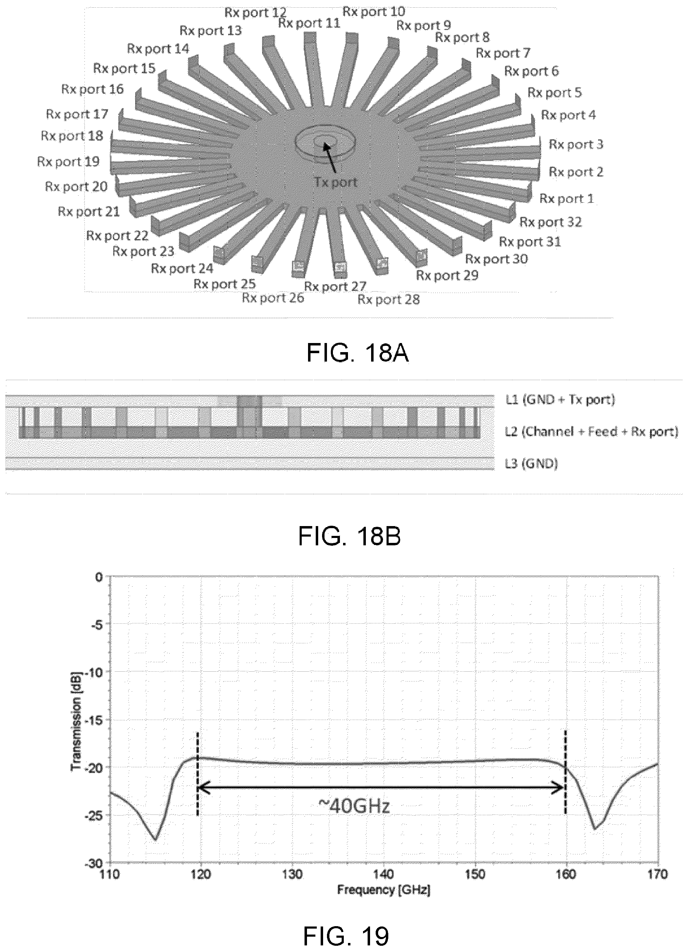

Each TX or RX front-end circuit may be connected to one or more interconnect components (not depicted) that is exemplified here as a channel architecture, exemplarily illustrated in FIGs. 18A and 18B to transmit (TX front-end circuit) and/or receive (RX front-end circuit) passband signals to/from the channel architecture. As illustrated herein, the IC device 1700 may have a substrate (e.g. a package) 1701 on which the RX dies, the TX die 1760 and the front-end die 1730 are disposed. Illustratively, the channel architecture may also be disposed on the substrate (e.g. on the package). In some examples, the channel architecture may be disposed on the front-end die 1730. In some examples, the front-end die 1730 may be an IC package and the channel architecture may be disposed on the package of the front-end die 1730.

For efficient and effective signal integrity, the RX dies may be arranged in a grid (e.g. 6x6 gird with a space in the center of the grid), with each RX die may be disposed equidistantly spaced from its at least three neighboring dies. In some examples, the front-end die 1730 and/or the channel architecture may be centrally disposed within the grid surrounded by the RX dies. Illustratively, the RX dies may be positioned at the perimeter of the grid, forming four edges in a square/rectangular shape, while the front-end die 1730 and/or the channel architecture may be located at the center, which may be arranged to maintain an equal distance from each RX die at the four edges. Such symmetrical disposition of RX dies around the front-end die 1730 may provide a uniform distance and may minimize signal degradation or latency.

Furthermore, the TX die 1760 may be disposed in close proximity to the front-end die 1730. In this configuration, the connections between the dies and the respective front-end circuits are unidirectional, which may allow to accommodate a greater number of dies due to lack of respective transmit or receive circuits at each baseband/front-end circuit. Correspondingly, the TX die 1760 may be configured to broadcast information to the RX dies via the channel architecture. Illustratively, the TX die 1760 may send information in the control plane to control operation of the RX dies.

FIG. 18A and 18B show an illustrative example of a channel architecture in accordance with aspects described herein, while FIG. 18A shows the channel architecture from a diagonal perspective, FIG. 18B shows the cross section of the channel architecture. Illustratively, the channel architecture may be the communication medium to facilitate the communication between the TX die 1760 and the RX dies as illustratively described in FIG. 17 for the IC device 1700

The channel architecture may be a radial or a circular channel architecture with a TX port arranged at the central position, the TX port is to be connected to the TX die 1760 and multiple individual RX ports (e.g. 32 ports as illustrated) arranged around the circumference emanating outward from the central position to be connected to the RX dies. Each port may couple a respective front-end circuit that the front-end die 1430 includes. The channel architecture may be arranged such that there is an equidistant spacing between the TX port and each of the RX ports to minimize signal degradation and latency variations.

The RX ports may be arranged to interface with the RX dies to enable conveying of passband signals received at the channel architecture to the RX dies, which the passband signals are sent by the respective front-end circuit of the TX die 1760. Correspondingly, each respective front-end circuit of each RX die may receive the passband signals from the RX port. The TX port may be arranged to interface with the TX die 1760 to enable conveying of passband signals received from the respective front-end circuit of the TX die 1760 to the channel architecture. Correspondingly, the respective front-end circuit of the TX die may send the passband signals to the channel architecture via the TX port.

The channel architecture may have three layers. The first layer (L1) depicted in FIG. 18B illustrates the layer that includes the TX port and the ground connections. The second layer (L2) may include feeds connecting RX ports and the channel portion of the channel architecture and the RX ports. The third layer (L3) may be the ground layer. The channel architecture illustrated here may be disposed on the package in accordance with aspects described in FIG. 17.

FIG. 19 shows a graph example representing output of simulation results in accordance with the channel architecture illustrated in FIG. 18A and 18B. Although it is exhibited up to 20 dB of loss in the channel for about 40 GHz of bandwidth, the obtained signal to noise ratio (SNR) is sufficient to establish the broadcast communication.

The detailed description refers to the accompanying drawings that show, by way of illustration, specific details and aspects of this disclosure in which the disclosure may be practiced. Other aspects may be utilized and structural, logical, and electrical changes may be made without departing from the scope of the disclosure. The various aspects of this disclosure are not necessarily mutually exclusive, as some aspects of this disclosure can be combined with one or more other aspects of this disclosure to form new aspects.

The word "exemplary" is used herein to mean "serving as an example, instance, or illustration". Any aspect of the disclosure or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.).

The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. The terms "group (of)", "set (of)", "collection (of)", "series (of)", "sequence (of)", "grouping (of)", etc., and the like in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

The word "exemplary" is used herein to mean "serving as an example, instance, or illustration". Any aspect or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

Further, spatially relative terms, such as "beneath," "below," "lower," "above," "upper" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, unless otherwise specified the use of the ordinal adjectives "first", "second", "third" etc., to describe a common object, merely indicate that different instances of like objects are being referred to, and are not intended to imply that the objects so described must be in a given sequence, either temporally, spatially, in ranking, or in any other manner.

The term "semiconductor substrate" is defined to mean any construction including semiconductor material, for example, a silicon substrate with or without an epitaxial layer, a silicon-on-insulator substrate containing a buried insulator layer, or a substrate with a silicon germanium layer. The term "integrated circuits" as used herein refers to electronic circuits having multiple individual circuit elements, such as transistors, diodes, resistors, capacitors, inductors, and other active and passive semiconductor devices.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

As used herein, a signal that is "indicative of" a value or other information may be a digital or analog signal that encodes or otherwise communicates the value or other information in a manner that can be decoded by and/or cause a responsive action in a component receiving the signal. The signal may be stored or buffered in computer readable storage medium prior to its receipt by the receiving component and the receiving component may retrieve the signal from the storage medium. Further, a "value" that is "indicative of" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As utilized herein, terms "module", "component," "system," "circuit," "element," "slice," "circuitry," and the like are intended to refer to a set of one or more electronic components, a computer-related entity, hardware, software (e.g., in execution), and/or firmware. For example, circuitry or a similar term can be a processor, a process running on a processor, a controller, an object, an executable program, a storage device, and/or a computer with a processing device. By way of illustration, an application running on a server and the server can also be circuitry. One or more circuits can reside within the same circuitry, and circuitry can be localized on one computer and/or distributed between two or more computers. A set of elements or a set of other circuits can be described herein, in which the term "set" can be interpreted as "one or more."

As used herein, "memory" is understood as a computer-readable medium (e.g., a non-transitory computer-readable medium) in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D Points, among others, or any combination thereof. Registers, shift registers, processor registers, data buffers, among others, are also embraced herein by the term memory. The term "software" refers to any type of executable instruction, including firmware.

The term "antenna" or "antenna structure", as used herein, may include any suitable configuration, structure and/or arrangement of one or more antenna elements, components, units, assemblies and/or arrays. In some aspects, the antenna may implement transmit and receive functionalities using separate transmit and receive antenna elements. In some aspects, the antenna may implement transmit and receive functionalities using common and/or integrated transmit/receive elements. The antenna may include, for example, a phased array antenna, a single element antenna, a set of switched beam antennas, and/or the like.

It will be understood that when an element is referred to as being "connected" or "coupled" to another element, it can be physically connected or coupled to the other element such that current and/or electromagnetic radiation (e.g., a signal) can flow along a conductive path formed by the elements. Intervening conductive, inductive, or capacitive elements may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "applied" to an element, the voltage, current, or signal may be conducted to the element by way of a physical connection or by way of capacitive, electro-magnetic, or inductive coupling that does not involve a physical connection.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

The term "operatively connected" as used herein may describe a connection between two elements, such that a first element operates or functions using as input the output of a second element. According to an aspect of the disclosure, "operatively connected" may describe an electrically conductive connection. That is, two elements that are operatively connected as described herein may be electrically conductively connected such that an electric charge may travel from the first element to the second element.

In example 1, the subject matter includes an integrated circuit device that may include: a plurality of integrated circuit dies, wherein at least a part of an integrated circuit die of the plurality of integrated circuit dies is configured to receive or transmit a respective baseband signal; a further integrated circuit die may include: a plurality of front-end circuits, wherein each front-end circuit of the plurality of front-end circuits is coupled to a respective integrated circuit die of the plurality of integrated circuit dies. In a version of example 1 applicable to other examples, each integrated circuit die of the plurality of integrated circuit dies may be configured to receive or transmit a respective baseband signa.

In example 2, the subject matter of example 1, wherein the further integrated circuit die includes one or more local oscillator configured to provide one or more oscillator signals to the plurality of front-end circuits.

In example 3, the subject matter of example 2, wherein each front-end circuit is coupled to the local oscillator to receive the oscillator signal; wherein each front-end circuit is configured to perform up-conversion and/or down-conversion based on the oscillator signal.

In example 4, the subject matter of any one of examples 1 to 3, further may include a broadcast interface coupled to the plurality of front-end circuits; wherein at least one front-end circuit of the plurality of front-end circuits is configured to: up-convert the respective baseband signal received from the respective integrated circuit die coupled to the at least one front-end circuit to obtain a passband signal; and transmit the passband signal via the broadcast interface.

In example 5, the subject matter of example 4, wherein at least one other front-end circuit of the plurality of front-end circuits is configured to: receive the passband signal from the broadcast interface; down-convert the passband signal received from the broadcast interface to obtain a received baseband signal; transmit the received baseband signal to the respective integrated circuit die coupled to at least one other front-end circuit.

In example 6, the subject matter of example 5, wherein the at least one front-end circuit includes a single front-end circuit may include a transmitter circuit coupled to the respective integrated circuit die to receive the respective baseband signal transmitted by the respective integrated circuit die; wherein the at least one other front-end circuit includes other front-end circuits of the plurality of front-end circuits, each other front-end circuit may include a respective receiver circuit coupled to the respective integrated circuit die.

In example 7, the subject matter of example 6, wherein each respective receiver circuit is configured to: receive the passband signal from the broadcast interface; down-convert the passband signal received from the broadcast interface to obtain the respective baseband signal; transmit the respective baseband signal to the respective integrated circuit die coupled to the respective receiver circuit.

In example 8, the subject matter of any one of examples 4 to 7, wherein the broadcast interface is formed on the further die or on a substrate external to the further die.

In example 9, the subject matter of any one of examples 1 to 3, further may include a broadcast interface; wherein each front-end circuit includes a respective transmitter circuit coupled to the respective integrated circuit die to receive the respective baseband signal transmitted by the respective integrated circuit die.

In example 10, the subject matter of example 9, wherein each respective transmitter circuit is coupled to the respective integrated circuit via a respective transmission line.

In example 11, the subject matter of example 9 or example 10, wherein each front-end circuit includes a respective receiver circuit coupled to the respective integrated circuit die to transmit the respective baseband signal to the respective integrated circuit die.

In example 12, the subject matter of example 10, wherein each respective receiver circuit is coupled to the respective integrated circuit via a respective transmission line.

In example 13, the subject matter of any one of examples 3 to 12, wherein the broadcast interface is couplable to a further integrated circuit device external to the integrated circuit device; wherein at least one of the plurality of integrated circuit dies is configured to instruct at least one respective front end circuit coupled to the at least one of the plurality of integrated circuit dies is configured to send the respective baseband signal to the further integrated circuit device.

In example 14, the subject matter of example 13, wherein the further integrated circuit device includes a chiplet; wherein the integrated circuit device is configured to communicate with the chiplet via the broadcast interface.

In example 15, the subject matter of any one of examples 3 to 14, wherein the broadcast interface includes a broadcast interconnect having a plurality of ports; wherein each port is connected to a respective front-end circuit of the plurality of front-end circuits.

In example 16, the subject matter of any one of examples 1 to 15, wherein the further integrated circuit die is a single die within which the plurality of front-end circuits are disposed.

In example 17, the subject matter of any one of examples 1 to 16, wherein the integrated circuit device includes one or more substrates; wherein the plurality of integrated circuit dies is disposed at different locations on one or more surfaces of the one or more substrates.

In example 18, the subject matter of example 17, wherein the plurality of integrated circuit dies are arranged in a grid on a surface of the one or more substrates, and wherein the further die is arranged at a center of the grid.

In example 19, an integrated circuit package may include: a first integrated circuit device may include the integrated circuit device of any one of examples 1 to 18; a second integrated circuit device coupled to the first integrated circuit device and may include a further front-end circuit configured to communicate with the plurality of front-end circuits of the first integrated circuit device.

In example 20, an integrated circuit may include: a plurality of dies, wherein each die of the plurality of is configured to communicate via a respective baseband signal; a further die may include: a plurality of front-end circuits, wherein each front-end circuit of the plurality of front-end circuits is coupled to a respective die of the plurality of dies.

In example 21, the integrated circuit of the example 20 may include any aspects described in examples 1-20 and/or any other aspects described herein.

## Claims

1. An integrated circuit device comprising:
a plurality of integrated circuit dies, wherein at least a part of an integrated circuit die of the plurality of integrated circuit dies is configured to receive or transmit a respective baseband signal; and
a further integrated circuit die comprising: a plurality of front-end circuits, wherein each front-end circuit of the plurality of front-end circuits is coupled to a respective integrated circuit die of the plurality of integrated circuit dies.

2. The integrated circuit device of claim 1,
wherein the further integrated circuit die comprises one or more local oscillator configured to provide one or more oscillator signals to the plurality of front-end circuits;
preferably wherein each front-end circuit is coupled to the local oscillator to receive the oscillator signal; and wherein each front-end circuit is configured to perform up-conversion and/or down-conversion based on the oscillator signal.

3. The integrated circuit device of any one of claims 1 or 2, further comprising:
a broadcast interface coupled to the plurality of front-end circuits; and
wherein at least one front-end circuit of the plurality of front-end circuits, which the at least one front-end circuit is coupled to the integrated circuit die, is configured to:
up-convert the respective baseband signal received from the respective integrated circuit die coupled to the at least one front-end circuit to obtain a passband signal; and
transmit the passband signal via the broadcast interface.

4. The integrated circuit device of claim 3,
wherein at least one other front-end circuit of the plurality of front-end circuits is configured to:
receive the passband signal from the broadcast interface;
down-convert the passband signal received from the broadcast interface to obtain a received baseband signal; and
transmit the received baseband signal to the respective integrated circuit die coupled to at least one other front-end circuit.

5. The integrated circuit device of claim 4,
wherein the at least one front-end circuit comprises a single front-end circuit comprising a transmitter circuit coupled to the respective integrated circuit die to receive the respective baseband signal transmitted by the respective integrated circuit die; and
wherein the at least one other front-end circuit comprises other front-end circuits of the plurality of front-end circuits, each other front-end circuit comprising a respective receiver circuit coupled to the respective integrated circuit die.

6. The integrated circuit device of claim 5,
wherein each respective receiver circuit is configured to:
receive the passband signal from the broadcast interface;
down-convert the passband signal received from the broadcast interface to obtain the respective baseband signal; and
transmit the respective baseband signal to the respective integrated circuit die coupled to the respective receiver circuit.

7. The integrated circuit device of any one of claims 3 to 6,
wherein the broadcast interface is formed on the further die or on a substrate external to the further die.

8. The integrated circuit device of any one of claims 1 to 7,
further comprising a broadcast interface;
wherein each front-end circuit comprises a respective transmitter circuit coupled to a respective integrated circuit die of the plurality of integrated circuit dies to receive the respective baseband signal transmitted by the respective integrated circuit die.

9. The integrated circuit device of claim 8,
wherein each respective transmitter circuit is coupled to the respective integrated circuit via a respective transmission line.

10. The integrated circuit device of any one of claims 8 or 9,
wherein each front-end circuit comprises a respective receiver circuit coupled to the respective integrated circuit die to transmit the respective baseband signal to the respective integrated circuit die.

11. The integrated circuit device of any one of claims 9 or 10,
wherein each respective receiver circuit is coupled to the respective integrated circuit via a respective transmission line.

12. The integrated circuit device of any one of claims 8 to 11,
wherein the broadcast interface is couplable to a further integrated circuit device external to the integrated circuit device; and
wherein at least one of the plurality of integrated circuit dies is configured to instruct at least one respective front-end circuit coupled to the at least one of the plurality of integrated circuit dies is configured to send the respective baseband signal to the further integrated circuit device.

13. The integrated circuit device of claim 12,
wherein the further integrated circuit device comprises a chiplet; and
wherein the integrated circuit device is configured to communicate with the chiplet via the broadcast interface;
preferably wherein the broadcast interface comprises a broadcast interconnect having a plurality of ports; and wherein each port is connected to a respective front-end circuit of the plurality of front-end circuits.

14. The integrated circuit device of any one of claims 1 to 13,
wherein the further integrated circuit die is a single die within which the plurality of front-end circuits is disposed.

15. The integrated circuit device of any one of claims 1 to 14,
wherein the integrated circuit device comprises one or more substrates; and
wherein the plurality of integrated circuit dies is disposed at different locations on one or more surfaces of the one or more substrates;
preferably wherein the plurality of integrated circuit dies is arranged in a grid on a surface of the one or more substrates, and wherein the further die is arranged at a center of the grid.
